Europäisches Patentamt

European Patent Office

Office européen des brevets

(19)

(11) Numéro de publication: **0 508 035 A1**

## DEMANDE DE BREVET EUROPEEN

(12)

(21) Numéro de dépôt: **91870221.8**

(22) Date de dépôt: **27.12.91**

(51) Int. Cl.5: **C23C 18/30**

(30) Priorité: **12.04.91 BE 9100336**

(43) Date de publication de la demande:
**14.10.92 Bulletin 92/42**

(84) Etats contractants désignés:
**AT BE CH DE ES FR GB IT LI NL SE**

(71) Demandeur: **Laude, Lucien Diégo**
**64, Rue des Lilas**
**F-59330 Hautmont(FR)**

(72) Inventeur: **Laude, Lucien Diégo**
**64, Rue des Lilas**
**F-59330 Hautmont(FR)**

(74) Mandataire: **Schmitz, Yvon et al**
**Bureau Gevers S.A. rue de Livourne 7 bte 1**
**B-1050 Bruxelles(BE)**

(54) **Méthodes de métallisation de surfaces à l'aide de poudres métalliques.**

(57) L'application du procédé décrit dans l'invention résulte dans la métallisation de surface de matériaux diélectriques. Ce procédé comprend une première étape dans laquelle une poudre métallique, dont la taille des grains est comprise entre 10 et 5000 nm, est déposée,puis incorporée à la surface du matériau diélectrique. Dans la seconde étape du procédé, le matériau diélectrique ainsi imprégné de métal est immergé dans un bain autocatalytique ce qui provoque le recouvrement des zones imprégnées du matériau par une couche du métal contenu dans le bain suivant une épaisseur proportionnelle au temps d'immersion. Le procédé décrit dans l'invention permet de métalliser également des matériaux comme les oxydes, les polymères et les composites contenant ces oxydes et/ou ces polymères. Les caractéristiques des dépôts métalliques sont contrôlées par le type de métal, la taille et la géométrie des grains de poudre métallique d'une part, par le type et la structure des matériaux diélectriques recouverts de ces dépôts, d'autre part.

EP 0 508 035 A1

Les méthodes de métallisation de surfaces décrites dans cette invention sont a) principalement caractérisées par l'utilisation de poudres métalliques comme agent d'une métallisation initiale de ces surfaces et, secondairement, b) par divers techniques permettant d'intégrer, par voie chimique, thermique ou mécanique, ces poudres à la surface, ou sur une faible profondeur, de matériaux par ailleurs difficiles à métalliser, comme par exemple les isolants électriques (céramiques, verres, plastiques). Accessoirement, cette métallisation initiale peut être limitée à des zones réduites de ces surfaces par irradiation au moyen d'un faisceau laser déplacé sur les surfaces. Quelle que soit la technique d'intégration des poudres utilisées, qui permet de réaliser la métallisation initiale des surfaces, celles-ci sont ensuite recouvertes, uniquement dans les zones initialement métallisées, d'une couche métallique d'épaisseur variable pouvant atteindre plusieurs centaines de micromètres en utilisant les méthodes connues de dépôts métalliques sur substrats métalliques ou métallisés, par voie d'électrolyse (avec ou sans polarisation électrique du substrat vis-à-vis du bain électrolytique).

Il existe un intérêt industriel particulièrement grand à métalliser la surface des matériaux diélectriques qui sont par ailleurs des isolants électriques. Pour être efficace et exploitable industriellement, cette métallisation doit permettre de réaliser des films très adhérents, quelle que soit leur épaisseur, sur tout substrat diélectrique et quel que soit l'état de sa surface (polie, rugueuse, cristallisée ou amorphe). Ces applications se situent en métallurgie : durcissement des surfaces et résistance à l'abrasion, l'électronique : interconnection dans les circuits hybrides, l'optique : métallisation des miroirs, la chimie : passivation aux agents chimiques. Parmi les matériaux présentant le plus d'intérêt, on peut citer : alumine, silice, ferrites, polymères et tout composite de ces matériaux.

La difficulté majeure rencontrée pour métalliser ces matériaux réside dans leur nature chimique. Ils sont en effet constitués d'atomes associés entre eux par des liaisons très fortes, covalentes ou ioniques. A cause de ces liaisons qui sont présentes à leur surface, tout atome étranger qui y est déposé se trouve ainsi lié à cette surface uniquement par des forces d'origine dipolaire, donc relativement faibles vis-à-vis des forces interatomiques intrinsèques à la surface du substrat. Cette physisorbtion est en général responsable de l'adhérence des films obtenus par évaporation sous vide, en particulier sur substrat diélectrique.

Accroître l'adhérence des films métalliques peut se faire suivant 2 voies : a) accroître la surface effective de contact entre le film et le substrat; ou b) modifier la chimie de l'interface film/substrat. La première voie est d'ordre structurel. Elle consiste à rendre rugueuse la surface du substrat préalablement au dépôt (par voie classique) d'un film métallique. La deuxième voie (ou chimisorption) implique la formation de liaisons fortes entre les atomes de la surface, d'une part, et les atomes étrangers qui y sont déposés, d'autre part. Suivant les 2 voies, un traitement thermique de l'ensemble film/substrat suit le dépôt du film afin d'améliorer l'homogénéité de l'interface. Ce traitement thermique est pratiquement impossible à réaliser sur plastique.

Tout procédé de métallisation comprend une source de métal et une source d'énergie. Parmi les différentes techniques utilisées, le dépôt par pulvérisation cathodique est celui qui permet d'obtenir la meilleure adhérence sur substrat isolant. Sauf à utiliser un masque, cette technique ne peut cependant être utilisée pour faire des dépôts très fortement confinés ou reproduits en trop petit nombre. Récemment, un nouveau procédé a été développé qui consiste à utiliser un composé organo-métallique condensé en film mince sur la surface à métalliser. L'irradiation au moyen d'un faisceau laser de ce film produit la décomposition du composé. Alors que la partie volatile de la molécule organo-métallique est éliminée de la surface, celle-ci conserve l'ion métallique libéré par la décomposition. La surface se trouve ainsi partiellement métallisée. Elle peut alors être habillée d'un film métallique épais par électrolyse classique. Le procédé présente l'inconvénient de devoir réaliser préalablement le film organo-métallique, ce qui constitue une difficulté lorsque la surface à habiller n'est pas plane ou a une géométrie très découpée. C'est aussi une étape supplémentaire par rapport à toutes les autres méthodes de dépôt de film. Le traitement de ce film peut se faire avec un laser à ion Ar$^+$ ou un laser excimère.

Le procédé qui fait l'objet de cette invention apporte un progrès important par rapport aux méthodes existantes de métallisation des surfaces de matériaux isolants électriques, réfractaires thermiques ou, au contraire, à faible capacité calorifique et faible diffusivité thermique. La source de métal est directement une poudre du métal qu'on souhaite appliquer à la surface. L'application de ce métal sur la surface peut se faire par voie liquide, facile à réaliser, et non par vaporisation sous vide. Le traitement de ce même dépôt métallique est réalisé à l'air libre, avantageusement par irradiation laser excimère mais aussi par d'autres voies peu onéreuses, en particulier thermique dans un four ouvert (en particulier à micro-onde). Le traitement laser offre la possibilité de traiter discrètement le film par balayage du faisceau laser, préalablement 'ocalisé ou non, suivant les techniques optiques connues. Enfin, le procédé permet de métalliser une surface avec tout métal, pour autant que celui-ci puisse être préparé sous forme de poudre, possédant avantageusement une taille de grain inférieure à 100 nm. L'ensemble de ces caractéristiques peut être étendu à des matériaux aussi divers que les verres et les plastiques, sans adaptation particulière. Le procédé est donc d'application universelle à ces matériaux, contrairement aux autres procédés. Sa mise en pratique est extrêmement simplifiée permettant son automatisation à un coût très inférieur aux autres procédés pour une efficacité très supérieure en terme d'adhérence.

La méthode décrite dans cette invention consiste à utiliser, comme source de métal, une poudre formée de grains de taille variable, comprise entre 10 et 5000 nm, préférentiellement de 20 à 100 nm, et une source d'énergie représentée par un faisceau laser, préférablement excimère. Dans un premier temps la poudre métallique est introduite dans un liquide volatil, comme par exemple du chloroforme, pour former une suspension. Cette suspension peut être ensuite appliquée sur la surface à habiller par tamponnage ou tout autre moyen. La pièce à métalliser peut être encore immergée totalement dans la suspension puis retirée à l'air. Après séparation de la matière volatile (par évaporation) les particules métalliques restent fixées sur la surface du substrat sous la forme d'un film solide. L'irradiation par le faisceau laser sert alors deux objects : a) traiter le substrat, soit par voie thermique (laser à ion, par exemple), soit par irradiation d'une longueur d'onde appropriée, soit par ablation (laser excimère), et b) transférer de l'énergie aux particules métalliques leur permettant de migrer à l'intérieur du substrat.

Suivant le type de substrat, on choisit le rayonnement laser qui permet le meilleur couplage optique avec ce substrat. Ce couplage peut opérer par voie thermique (laser à ions travaillant dans le visible) par transfert de l'énergie photonique sur les sites d'impureté ou de défaut dans les céramiques (alumine, silice, composite) ou par voie électronique (laser excimère travaillant dans l'ultra-violet) en excitant des électrons de valence. Dans ce dernier cas, le choix de la longueur d'onde d'émission du laser excimère dépend du seuil d'absorption optique du matériau irradié, par exemple 193 nm pour le quartz. Comme on le verra dans les différents exemples d'application qui sont décrits plus loin, la méthode est particulièreemnt bien adaptée aux matériaux polymères qui possèdent une faible capacité thermique (dégradation à température inférieure à 300°C) et une faible diffusivité thermique, comme par exemple le polycarbonate qui peut être irradié très avantageusement à 308 ou 248 nm. Elle permet aussi de réaliser successivement et avec la même géométrie, la gravure et la métallisation de diélectriques "durs" (quartz, alumine) en intégrant dans ces matériaux et à une profondeur pouvant atteindre 1 mm, des pistes métalliques épaisses (~ 0.5 mm) et très adhérentes, pouvant respecter des spécifications très élevées.

Enfin, le type de substrat diélectrique ("dur" ou "moux") détermine le choix de la taille des grains métalliques de la poudre utilisée. Ce choix permet en particulier un "habillage" très dense des zones irradiées, réalisant une première couche métallique très adhérente sur le substrat. En particulier, la durée des pulsations d'un laser excimère n'excédant pas 30 nsec, le couplage optique de ce faisceau laser avec un polymère peut être choisi de telle façon à induire soit l'ablation, la cristallisation, la réticulation ou la fusion du plastique simultanément à un couplage très intense, en toute situation, avec les particules métalliques. Celles-ci sont ainsi portées à température élevée pendant un temps très court pendant lequel elles pénètrent dans une matrice polymère en cours de transformation. Cette pénétration présente un gradient sur plusieurs microns dans le polymère, formant ainsi une couche d'accrochage métallique très efficace sans carbonisation du matériau polymère. Comme on le verra dans les exemples présentés, ce procédé n'est pas spécifique d'un métal mais s'applique à tout métal mis en forme de poudre.

Pour toutes les variantes de production de cette couche métallique préliminaire d'accrochage, les substrats ainsi recouverts sont plongés ensuite dans un bain électrolytique sans polarisation ("électroless") afin d'accroître l'épaisseur du film métallique préalablement déposé. Ce deuxième dépôt n'opère que dans les zones précédemment métallisées, c'est-à-dire irradiées.

Plusieurs variantes de la méthode présentée dans cette invention sont décrites dans les exemples décrits plus loin et qui se rapportent à la métallisation de verres ou de plastiques. Ces exemples ne sont pas limitatifs et peuvent être étendus à d'autres matériaux diélectriques sans s'écarter des principes généralement décrits plus haut.

Exemple 1

Impression par voie laser d'une poudre métallique sur la surface d'un verre

Un substrat de verre est revêtu en utilisant une tournette ("spinning")d'un film métallique. La suspension utilisée est constituée de chloroforme contenant en suspension une poudre métallique. Après évaporation du liquide volatil, le verre est recouvert d'un dépôt discontinu de grains métalliques de Cu d'un Ø moyen de 80 nm, puis exposé à un faisceau laser. Deux types de laser ont été utilisés : a. Laser à ion Ar$^+$ (longueur d'onde = 514 nm). Le film métallique absorbe la lumière du laser et sa température s'accroît.

3

Par suite, le substrat de verre s'échauffe lui-même et ce chauffage localisé du substrat génère une contrainte mécanique dans celui-ci qui résulte dans la formation de microcraquelures à sa surface. Celles-ci capturent les particules métalliques qui migrent ainsi vers l'intérieur du substrat de verre. Typiquement, la puissance laser utilisée est de 4 W, diamètre du faisceau 200 $\mu$m à l'impact sur le verre. Le faisceau est déplacé à 1 mm/sec sur la surface. Le procédé produit des bandes métallisées de Cu (poudre de cuivre de Ø 80 nm) sur la surface du verre, avec une pénétration comprise de 1 à 5 $\mu$m.

b. Laser excimère à KrF (longueur d'onde = 248 nm). L'absorption optique opère à la fois sur les grains métalliques et sur le verre. Pour une densité d'énergie voisine de 1 J/cm$^2$, l'irradiation laser résulte dans l'impression de la poudre métallique de Cu (Ø 80 nm) dans le verre. Cette impression est ici inhomogène, l'irradiation est accompagnée de la formation d'une "plume" de matière émise par le film dans l'axe du faisceau. A plus forte énergie, on observe l'ablation de matière uniquement, et à plus faible énergie on n'obtient pas d'impression.

Exemple 2

Transfert de poudre métallique sur un verre

Un film est préparé comme dans l'exemple 1, sur une plaque de quartz. Le substrat de verre est appliqué contre cette plaque ou est disposé à très faible distance de celui-ci. Le film métallique sur quartz est disposé du côté du substrat de verre. La plaque de quartz est alors irradiée, au travers d'un masque, côté non recouvert du film. Cette irradiation produit l'émission du métal sur la face opposée du quartz, vers le substrat de verre qui est ainsi recouvert d'un film dont la géométrie épouse exactement celle du masque. Ce film est ensuite recouvert par voie autocatalytique d'un film plus épais d'un métal identique ou non au métal premier déposé.

Exemple 3

Gravure d'une plaque de verre par laser et habillage de la gravure avec une poudre métallique

Une plaque de verre d'épaisseur pouvant atteindre plusieurs millimètres est préalablement irradiée par un laser excimère travaillant à 248 nm de longueur d'onde. Des microcraqueldures sont produites à sa surface en un réseau très dense s'étendant jusqu'à une profondeur de 300 nm à l'intérieur du verre pour une énergie de 1 J par mm$^2$. A la suite de l'irradiation répétée par un train de pulsations superposées sur la même zone irradiée, ces craquelures sont multipliées. Au bout d'une centaine de pulsations, un sillon est creusé à l'intérieur du verre sur une profondeur de quelques micromètres. La surface interne de ce sillon est habillée de fissures dont la largeur est de l'ordre de 50 à 100 nm. Une suspension de poudre métallique dans du chloroforme, poudre dont les grains ont un diamètre comparable à la dimension des fissures (par exemple, ici 80 nm) est alors répartie sur le verre. Les particules métalliques viennent s'incruster dans ces fissures où elles sont piégées, alors que les particules déposées hors des sillons, étant faiblement liées au verre, sont facilement éliminées par frottement d'un tissu ou d'un outil plat. La pièce de verre est alors plongée dans une solution de placage chimique contenant des ions de nickel, dont la composition est connue de l'art. Ceux-ci se condensent alors dans les sillons, au contact des particules métalliques préalablement incrustés dans ces sillons. Des sillons adjacents ou se croisant peuvent être ainsi remplis de métaux différents. Pour cela, un premier sillon est ainsi habillé d'un ruban de Nickel. Comme le Nickel est catalytiquement actif vis-à-vis d'un dépôt métallique de Cu, ce ruban de Ni doit être électriquement isolé. On réalise ceci en plongeant la pièce de verre dans une solution choroformique dans laquelle une quantité de polyméthylméthacrylate (PMMA)est au préalable dissoute. La pièce est retirée de la solution et le chloroforme s'évapore laissant une couche de PMMA (d'épaisseur pouvant être de l'ordre de 5 à 20 $\mu$m). Un deuxième sillon est alors gravé dans le verre pour intercepter le premier sillon. Cette gravure est faite en irradiant la surface couverte de PMMA par un faisceau excimère travaillant à 248 nm qui ablate le PMMA et le verre sous-jacent dans la zone irradiée. Le deuxième sillon est alors imprégné d'une suspension contenant une poudre de Cu (Ø des grains égale à 30 nm). Après immersion dans une solution électrolytique contenant des ions de cuivre, ce deuxième sillon est alors occupé par un ruban de cuivre qui vient intercepter le premier ruban de nickel. Le PMMA permet ici d'interdire tout dépôt de Cu hors des zones irradiées au cours de la deuxième irradiation. Le PMMA restant est alors éliminé de la surface par immersion de la pièce dans un bain de solvant spécifique du PMMA (chloroforme ou acétone). On a alors produit un thermocouple Cu-Ni gravé sur la plaque de verre et dont la surface active correspond à la zone de superposition des deux rubans Ni et Cu. Cette zone a une surface uniquement limitée par la taille du faisceau laser excimère ayant servi à la gravure. Elle peut avoir une dimension comprise entre 50 et 500 $\mu$m.

Lorsque ces deux rubans sont exactement superposés, un traitement laser ou thermique supplémentaire permet aussi de préparer des dépôts linéaires épais d'alliages.

Exemple 4

Fixation d'une poudre métallique sur la surface d'un polymère solide

On utilise une poudre de cuivre dont le diamètre moyen des particules est de 80 nm. Une suspension de cette poudre est préparée dans un récipient contenant du chloroforme et une quantité de poudre à raison de 1 cm$^3$ de poudre pour 50 cm$^3$ de chloroforme. Les particules s'agglomèrent sous forme de billes de diamètre de l'ordre de quelques dizaines de micromètres. Pour éliminer ces agglomérats, le récipient contenant la suspension est partiellement immergé dans un bain à ultra-son . Après quelques secondes d'immersion, la dispersion des particules est maximum et les agglomérats ont disparu. Une fraction de la suspension est alors prélevée, puis distribuée sur la surface de la pièce en PBT maintenue horizontalement. On peut aussi immerger la pièce dans la suspension, puis la retirer. Après évaporation du chloroforme, une mince pellicule métallique est alors fixée faiblement sur la surface du PBT. Cette surface est ensuite irradiée avec un faisceau laser Ar$^+$ balayé sur la surface après focalisation pour atteindre une densité de puissance de l'ordre de 0.3 Wcm$^{-2}$ à l'impact sur la surface. Pendant l'irradiation, les particules métalliques s'échauffent et la pellicule superficielle du polymère fond sur quelques micromètres de profondeur. Ces particules diffusent sur cette profondeur ce qui permet d'imprégner très fortement le polymère avec le métal de la suspension initiale.

Après irradiation, la pièce en PBT est immergée dans un bain d'eau à ultra-son pendant 5 minutes ce qui détache les particules métalliques faiblement fixées sur la surface non-irradiée de la pièce en PBT. Les particules ainsi récupérées peuvent être à nouveau re-utilisées pour recouvrir une autre pièce par la procédure décrite plus haut.

Après nettoyage dans le bain à ultra-son, la pièce est alors plongée dans une solution de placage chimique dont la composition est la suivante (pour 1 l. d'eau) :

| | |
|---|---|
| CuSO$_4$ | 25 à 35 g. |
| NaOH | 30 à 40 g. |
| Na$_2$CO$_3$ | 20 à 30 g. |
| EDTA | 80 à 90 g. |
| Formol | 20 à 25 ml. |

Un dépôt métallique de cuivre se développe alors à partir et autour des particules métalliques, intégrées dans la surface du PBT au cours de la première partie du procédé. La vitesse de dépôt est de l'ordre de 10 $\mu$m/heure. Le même résultat est obtenu sur une plaque de verre avec une densité de puissance laser de 1 Wcm$^{-2}$.

Exemple 5

Métallisation d'un substrat polymère en utilisant un solvant du polymère

Au contraire de l'exemple 4, la suspension de poudre métallique est ici réalisée dans un solvant spécifique du polymère à métalliser.

Pour métalliser la surface d'une pièce en polycarbonate, on prépare une suspension de poudre de Zinc (taille moyenne des particules métalliques : 10$\mu$m) dans du DMPhA, suivant une proportion variable. Le DMPhA contenant la poudre est alors étalé sur la surface du polycarbonate. Avant que le solvant ne soit totalement évaporé, la surface est attaquée et les particules de Zinc sont ainsi intégrées au voisinage de la surface. La pièce ainsi traitée est alors immergée dans la solution suivante (pour 1 l. d'eau) :

EP 0 508 035 A1

| NiCl$_2$ | 30 g. |
| NaH$_2$PO$_2$ | 10 g. |
| NaCH$_3$COO | 10 g. |

La solution est portée à 95°C et la vitesse de dépôt de Nickel est de l'ordre de 10 à 15 $\mu$m/heure sur toute la surface imprégnée au préalable de poudre de Zinc.

Exemple 6

Métallisation d'un substrat polymère ou composite polymère en utilisant un four à micro-onde

On prépare une suspension contenant une poudre métallique suivant la méthode décrite dans l'exemple 4. Cette suspension est appliquée sur la surface d'une pièce en polymère quelconque, soit par tamponnage au travers d'un masque appliqué sur la pièce, soit par application avec la pointe d'un feutre imprégné de la suspension. La pièce ainsi préparée est placée dans un four à micro-onde délivrant 500 à 800 W, pendant une durée variant de quelques secondes à quelques minutes. Seules les particules métalliques captent le rayonnement émis par le four et s'échauffent en conséquence. Le substrat polymère fond localement au contact des particules qui diffusent alors profondément dans le polymère. La profondeur moyenne de pénétration des particules dans le polymère est directement proportionnelle au temps de présence de la pièce dans le four maintenu à une puissance de travail fixe. Cette profondeur dépend aussi de la taille des particules : elle augmente avec le diamètre des particules. Après traitement dans le four, un dépôt "électroless" est réalisé.

On peut ainsi, par exemple, métalliser une pièce de polycarbonate avec une poudre de cuivre de 80 nm de diamètre.

Exemple 7

Métallisation d'un substrat polymère ou composite polymère par pression à chaud

La poudre métallique est déposée sur un substrat polymère comme dans l'exemple 4. Ensuite, la totalité ou une partie de la couche métallique faiblement adhérente sur le polymère est traitée par un outil chaud appliqué sur cette surface. Celui-ci fait pénétrer les particules métalliques dans le substrat sur toute la surface de contact.

Après pression à chaud, la pièce traitée est immergée dans un bain à ultra-son ce qui élimine de la pièce les particules non-traitées par pression à chaud. La pièce est ensuite immergée dans un bain "électroless" pour produire un dépôt métallique uniquement dans les zones de la pièce préalablement imprégnées à chaud de poudre métallique.

On réalise ainsi la métallisation de feuille de PA 6.6 (toutes épaisseurs) avec une poudre de Cu (80 nm diamètre des particules), suivie d'un dépôt (par "électroless") de Nickel ou Cuivre. La forme particulière de l'invention décrite dans cette exemple est bien adaptée à une métallisation en ligne et continue d'une feuille plastique suivant une piste de largeur comprise entre 50 $\mu$m et 1 mm de largeur.

**Revendications**

1. Procédé de métallisation de la surface de matériaux diélectriques, procédé comprenant une suite de deux étapes successives dont la première consiste en l'incorporation de poudre métallique fine dont la taille des grains est comprise entre 10 et 5000 nm, sur la surface du matériau diélectrique, et dont la seconde consiste à immerger la pièce ainsi imprégnée de poudre métallique dans un bain autocatalytique provoquant le recouvrement des zones imprégnées de la pièce par une couche du métal contenu dans le bain suivant une épaisseur proportionnelle au temps d'immersion :

2. Procédé de métallisation tel que décrit dans la revendication 1 caractérisé en ce que la surface du matériau diélectrique est recouverte d'une couche d'une suspension liquide contenant la poudre métallique, provoquant, après évaporation de la partie volatile de la suspension, la sédimentation d'une couche solide de poudre métallique sur la surface du matériau diélectrique ;

3. Procédé de métallisation tel que décrit dans les revendications 1 et 2, caractérisé en ce que la

6

suspension liquide contenant la poudre métallique est formée d'un liquide capable d'attaquer chimiquement la surface du matériau diélectrique ;

4. Procédé de métallisation tel que décrit dans les revendications 1 et 2, caractérisé en ce que la couche solide de poudre métallique, sédimentée sur la surface du matériau diélectrique, est irradiée par un faisceau laser provoquant l'incorporation de cette poudre dans le matériau, dans le voisinage immédiat de sa surface ;

5. Procédé de métallisation tel que décrit dans les revendications 1, 2 et 3 caractérisé en ce que le matériau diélectrique recouvert de la couche sédimentée et fixée sur la surface de ce matériau diélectrique par attaque chimique de sa surface, est placé dans un four à micro-onde provoquant la diffusion des grains métalliques de la couche sédimentée dans le matériau sur une profondeur variable et fonction du temps pendant lequel le matériel est dans le four à micro-onde ;

6. Procédé de métallisation tel que décrit dans la revendication 1 caractérisé en ce que le matériau diélectrique est transparent au rayonnement du laser, que ce matériau est irradié par ce rayonnement au travers de sa surface avant, et que sa surface arrière est en contact direct avec la suspension liquide contenant la poudre métallique, l'irradiation par le faisceau laser, suivant l'agencement décrit, de l'ensemble formé du matériau diélectrique et de la suspension provoquant le dépôt, sur la surface arrière du matériau diélectrique, d'une couche du métal constituant la poudre en suspension dans le liquide ;

7. Procédé de métallisation tel que décrit dans les revendications 1 et 2 caractérisé en ce qu'on applique sur la couche sédimentée de poudre métallique un timbre ou un poinçon, l'application provoquant la pénétration des grains de poudre métallique dans le matériau diélectrique dans les zones de ce matériau en contact direct avec la surface du timbre ou du poinçon appliquée ;

8. Procédé de métallisation tel que décrit dans les revendications 1, 2 et 7 caractérisé en ce que la surface du timbre ou du poinçon est portée à une température suffisante pour fondre la surface du matériau diélectrique et/ou la couche métallique, cette application provoquant le déplacement du métal dans les zones du matériau en contact direct avec la surface du timbre ou du poinçon ;

9. Procédé de métallisation tel que décrit dans les revendications 1 et 2 caractérisé en ce que la couche métallique est sédimentée sur un support plan diélectrique transparent au rayonnement laser, que la surface de ce support recouverte de la couche métallique est mise au contact de la surface plane d'un second matériau, diélectrique ou non, et que l'ensemble formé par ce matériau et le support plan recouvert sur une de ses 2 faces de la couche métallique est irradié au travers de la face libre du support diélectrique, l'irradiation provoquant le transfert du métal entre le support plan diélectrique et la surface plane du second matériau.

10. Procédé de métallisation tel que décrit dans la revendication 1 caractérisé en ce que la surface du matériau diélectrique est gravée mécaniquement avec un outil en contact avec cette surface et déplacé sur celle-ci suivant un parcours prédéterminé qui provoque ainsi une gravure spécifique de cette surface sous la forme de trous ou de sillons, ces trous ou ces sillons étant ensuite simplement comblés d'une poudre métallique dont le diamètre des grains est inférieur à 100 nm, et sans autre traitement supplémentaire, avant d'immerger le matériau diélectrique dans le bain autocatalytique ;

11. Procédé de métallisation tel que décrit dans la revendication 1 caractérisé en ce que la surface du matériau diélectrique est gravée à l'aide d'un faisceau laser irradiant la surface du matériau, cette gravure étant ensuite simplement comblée d'une poudre métallique dont le diamètre des grains est inférieur à 100 nm et sans autre traitement supplémentaire, avant d'immerger le matériau diélectrique dans le bain autocatalytique ;

12. Procédé de métallisation tel que décrit dans les revendications 1 , 10 et 11 caractérisé en ce que l'application de la poudre métallique dans les sillons de gravure du matériau diélectrique est suivie d'un traitement thermique de ce matériau, permettant ainsi une meilleure imprégnation métallique des infractuosités de la surface gravée, ce traitement thermique étant suivi de l'immersion du matériau diélectrique traité dans le bain autocatalytique ;

13. Procédé de métallisation tel que décrit dans les revendications 3, 4, 6, 9, 10, 11 et 12 caractérisé en ce que les dimensions latérales du dépôt métallique, qui est confiné dans les zones gravées du matériau diélectrique pour former une piste métallique, sont limitées par les dimensions latérales de l'outil ou du faisceau laser utilisé pour effectuer la gravure de la surface du matériau diélectrique ;

14. Procédé de métallisation tel que décrit dans les revendications 1 à 13 caractérisé en ce que les métaux et alliages utilisés appartiennent à la liste suivante : Ni, Cu, Ni-Co, Ni-Cu, Ni-Fe, Ni-Re, Ni-Co-Re, Ni-W, Co-W, Ni-Co-W, Co-Zn, Co-Fe, Co-Re, Cu-Co, Co-Mo, Co-Mn, Ag, Au, Pd, Pt, Sn, Cr, Cd, Fe, Pb ;

15. Procédé de métallisation tel que décrit dans les revendications 3, 4, 6, 9, 11, 12, 13 et 14 caractérisé en ce que ce procédé est utilisé plusieurs fois successivement sur la même pièce du matériau diélectrique, avec alternativement des matériaux ou alliages différents, pour former un réseau de pistes interconnectées ;

16. Procédé de métallisation tel que décrit dans les revendications 3, 4, 5, 6, 9, 11, 12, 13 et 14 caractérisé en ce que les poudres métalliques utilisées ont un diamètre de grain compris entre 100 et 5000 nm ;

17. Procédé de métallisation tel que décrit dans les revendications 3, 4, 5, 6, 9, 11, 12, 13 et 14 caractérisé en ce que les poudres métalliques utilisées ont un diamètre de grain choisi dans la gamme entre 10 et 100 nm de façon à permettre le contrôle précis de la profondeur de pénétration de ces grains dans le matériau diélectrique ;

18. Procédé de métallisation tel que décrit dans les revendications 1 à 17 caractérisé en ce que le matériau diélectrique appartient à la liste suivante : les oxydes diélectriques réfractaires, les polymères ou alliages de polymères, les composites, contenant ces oxydes et/ou ces polymères ;

19. Procédé de métallisation tel que décrit dans les revendications 1 à 18 caractérisé en ce que le matériau diélectrique est un monocristal, un polycristal, une poudre constituée de grains de tailles variées ou de taille unique, un verre, une fibre, un film déposé sur un substrat métallique ou isolant.

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| X | PATENT ABSTRACTS OF JAPAN vol. 11, no. 353 (C-457)(2800) 18 Novembre 1987 & JP-A-62 124 278 ( MITSUBISHI RAYON CO LTD ) 5 Juin 1987 * abrégé * | 1,2 | C23C18/30 |
| X | US-A-4 634 468 (GULLA) * colonne 16, ligne 50 * | 1,2 | |
| X | US-A-4 278 712 (THOMANN) * colonne 7; revendication 4 * | 1,2 | |
| A | PATENT ABSTRACTS OF JAPAN vol. 13, no. 156 (C-585)(3504) 14 Avril 1989 & JP-A-63 310 972 ( SHOWA DENKO KK ) 19 Décembre 1988 * abrégé * | | |
| A | PATENT ABSTRACTS OF JAPAN vol. 15, no. 92 (C-811)6 Mars 1991 & JP-A-2 305 969 ( MITSUBISHI ELECTRIC CORPORATION ) 19 Décembre 1990 * abrégé * | | |

DOMAINES TECHNIQUES RECHERCHES (Int. Cl.5 )

C23C

Le présent rapport a été établi pour toutes les revendications

| Lieu de la recherche | Date d'achèvement de la recherche | Examinateur |
|---|---|---|
| LA HAYE | 29 JUIN 1992 | NGUYEN THE NGHIEP N. |

CATEGORIE DES DOCUMENTS CITES

X : particulièrement pertinent à lui seul
Y : particulièrement pertinent en combinaison avec un
autre document de la même catégorie
A : arrière-plan technologique
O : divulgation non-écrite
P : document intercalaire

T : théorie ou principe à la base de l'invention
E : document de brevet antérieur, mais publié à la
date de dépôt ou après cette date
D : cité dans la demande
L : cité pour d'autres raisons
....................................................................
& : membre de la même famille, document correspondant

EPO FORM 1503 03.82 (P0402)